# EUROPEAN PATENT APPLICATION

(11) **EP 2 919 288 A1**
(43) Date of publication of application: **16.09.2015**
(21) Application number: 13852851.8
(22) Date of filing: 07.11.2013
(51) Int. Cl.: H01L 51/42, C08G 61/12

(54) **SOLAR CELL**

(30) Priority: 09.11.2012 JP 2012247439; 29.10.2013 JP 2013224467
(71) Applicant: Sekisui Chemical Co., Ltd., Osaka-shi, Osaka 530-0047 (JP)
(72) Inventor: OHARA, Shunji, Mishima-gun Osaka 618-0021 (JP); HAYAKAWA, Akinobu, Mishima-gun Osaka 618-0021 (JP); HORIKI, Mayumi, Mishima-gun Osaka 618-0021 (JP); ITO, Kazushi, Mishima-gun Osaka 6180021 (JP)
(74) Representative: Hart-Davis, Jason
(86) International application number: PCT/JP2013/080081
(87) International publication number: WO 2014/073592

(57) **Abstract**

The present invention aims to provide a solar cell having high photoelectric conversion efficiency and excellent durability. The present invention relates to a solar cell including at least: a cathode; an anode; a photoelectric conversion layer provided between the cathode and the anode; and a hole transport layer provided between the photoelectric conversion layer and the anode, the hole transport layer containing an organic semiconductor, the organic semiconductor having a carboxyl group and having a conjugated structure.

## Description

### TECHNICAL FIELD

The present invention relates to a solar cell having high photoelectric conversion efficiency and excellent durability.

### BACKGROUND ART

Conventionally, a photoelectric conversion element prepared by laminating plural kinds of semiconductor layers and then providing electrodes on both sides of the resulting laminate has been developed. The use of a composite film prepared by mixing and complexing plural kinds of semiconductors, instead of a laminate as mentioned above, has been also considered. In such a photoelectric conversion element, each semiconductor serves as a P-type semiconductor or N-type semiconductor, and photocarriers (electron-hole pair) are generated in the P-type semiconductor or N-type semiconductor by photoexcitation, so that the electron moves in the N-type semiconductor and the hole moves in the P-type semiconductor. In this manner, an electric field is generated.

At the present, many of practically used photoelectric conversion elements are inorganic solar cells produced using inorganic semiconductors such as silicon. Production of inorganic solar cells is, however, costly and size increase of such solar cells is difficult. As a result, an application range of the solar cells is limited. For these reasons, organic solar cells (see Patent Literatures 1 and 2, for example) produced using organic semiconductors, instead of inorganic semiconductors, are drawing attentions.

In many organic solar cells, a hole transport layer is provided between an anode and a photoelectric conversion layer containing an N-type semiconductor and a P-type semiconductor.

At the present, a hole transport layer is made from poly(3,4-ethylene dioxythiophene):poly(styrene sulfonate) (PEDOT:PSS) in most cases (see Patent Literature 3, for example). Since PEDOT:PSS is water-soluble, film forming properties are problematically poor. Moreover, because of its strong acidity, PEDOT:PSS becomes a cause of degradation of organic solar cells.

Use of an inorganic material such as metal oxides as a material of a hole transport layer is also considered. In this case, however, the photoelectric conversion efficiency is problematically lowered, though the durability is achieved to some extent.

### CITATION LIST

### - Patent Literature

Patent Literature 1: JP-A 2006-344794
Patent Literature 2: Japanese Patent No. 4120362
Patent Literature 3: JP-A 2006-237283

### SUMMARY OF INVENTION

### - Technical Problem

The present invention aims to provide a solar cell having high photoelectric conversion efficiency and excellent durability.

### - Solution to problem

The present invention relates to a solar cell including at least: a cathode; an anode; a photoelectric conversion layer provided between the cathode and the anode; and a hole transport layer provided between the photoelectric conversion layer and the anode, the hole transport layer containing an organic semiconductor, the organic semiconductor having a carboxyl group and having a conjugated structure.

The present invention is specifically described in the following.

The present inventors found out that when a solar cell includes at least: a cathode; an anode; a photoelectric conversion layer provided between the cathode and the anode; and a hole transport layer provided between the photoelectric conversion layer and the anode, the hole transport layer containing an organic semiconductor, the organic semiconductor having a carboxyl group and having a conjugated structure, the durability can be improved while the photoelectric conversion efficiency is kept high, thereby completing the present invention.

The solar cell of the present invention includes at least: a cathode; an anode; a photoelectric conversion layer provided between the cathode and the anode; and a hole transport layer provided between the photoelectric conversion layer and the anode.

The material of the cathode is not particularly limited, and a conventionally known material may be used. Examples thereof include sodium, sodium-potassium alloy, lithium, magnesium, aluminum, a magnesium-silver mixture, a magnesium-indium mixture, aluminum-lithium alloy, an Al/Al₂O₃ mixture, an Al/LiF mixture, SnO₂, FTO, AZO, IZO, GZO, and ITO. Each of these materials may be used alone, or two or more of these may be used in combination.

The material of the anode is not particularly limited, and a conventionally known material may be used. Examples thereof include metals such as gold, conductive transparent materials such as CuI, ITO (indium tin oxide), SnO₂, AZO, IZO, and GZO, and conductive transparent polymers. Each of these materials may be used alone, or two or more of these may be used in combination.

The hole transport layer contains an organic semiconductor having a carboxyl group and having a conjugated structure. Such a hole transport layer is stably and easily formed by coating application.

The organic semiconductor having a carboxyl group and having a conjugated structure is soluble in an organic solvent and has excellent film forming properties. Use of such an organic semiconductor increases the photoelectric conversion efficiency and also increases the durability of the solar cell of the present invention. In addition, because of its weak acidity, the organic semiconductor having a carboxyl group and having a conjugated structure is less likely to degrade the solar cell. Accordingly, the solar cell of the present invention has further improved durability.

The organic semiconductor having a carboxyl group and having a conjugated structure is not particularly limited. For example, the organic semiconductor preferably has a carboxyl group and has at least one structure selected from the group consisting of a thiophene structure, a paraphenylene vinylene structure, a vinyl carbazole structure, an aniline structure, an acetylene structure, a pyrrole structure, a perylene structure, a fluorene structure, an indoline structure, a spirobifluorene structure, a phthalocyanine structure, and a porphyrin structure. Alternatively, the organic semiconductor may have a structure of a derivative of any of these. In particular, at least one structure selected from the group consisting of a thiophene structure, a paraphenylene vinylene structure, an indoline structure, and a phthalocyanine structure is preferred. Moreover, a thiophene structure is more preferred because it has sulfur.

Specific examples of the thiophene structure include alkylthiophene, benzothiophene, ethylenedioxythiophene, and thienothiophene. In particular, alkylthiophene is preferred because the side chain thereof improves the solubility in an organic solvent, leading to improvement in film forming properties.

Since elongation of the conjugate length increases the mobility of carriers, the organic semiconductor having a carboxyl group and having a conjugated structure is preferably a conjugated polymer. In the case where the organic semiconductor having a carboxyl group and having a conjugated structure is a conjugated polymer, the weight average molecular weight is not particularly limited, and preferably, the lower limit is 10000 and the upper limit is 1000000. If the weight average molecular weight is more than 1000000, the organic semiconductor having a carboxyl group and having a conjugated structure may have lowered solubility in an organic solvent, possibly leading to lowered film forming properties.

Exemplary commercial products of the organic semiconductor having a carboxyl group and having a thiophene structure include P3CT (product of Rieke Metals Inc., conjugated polymer having a carboxyl group and having a thiophene structure, having a constituting unit represented by Formula (1)).

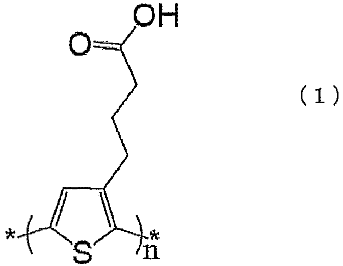

In Formula (1), n represents an integer.

Exemplary commercial products of the organic semiconductor having a carboxyl group and an indoline structure include D-149 (product of Sigma-Aldrich, having a structure represented by Formula (2)).

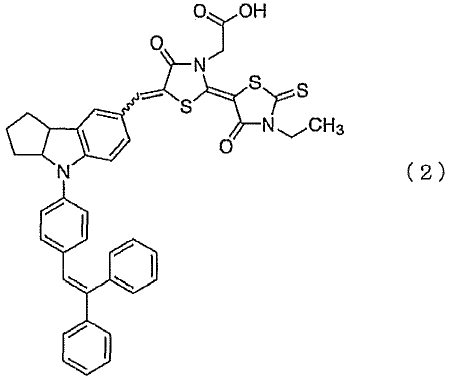

Examples of the organic semiconductor having a carboxyl group and having a paraphenylene vinylene structure include a paraphenylene vinylene derivative having a carboxyl group introduced thereinto (and having a constituting unit represented by Formula (3)).

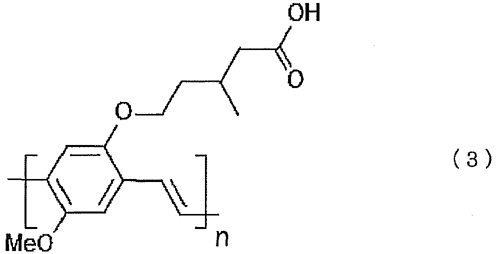

In Formula (3), n represents an integer.

Examples of the organic semiconductor having a carboxyl group and having a phthalocyanine structure include a phthalocyanine derivative having a carboxyl group introduced thereinto (and having a structure represented by Formula (4)).

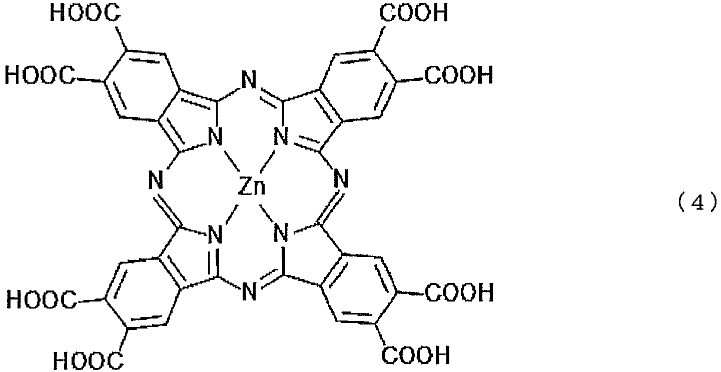

The lower limit of the thickness of the hole transport layer is preferably 1 nm and the upper limit thereof is preferably 2000 nm. When the thickness is 1 nm or more, electrons can be sufficiently blocked. When the thickness is 2000 nm or less, such a hole transport layer is less likely to be resistance upon hole transportation, avoiding a decrease in the photoelectric conversion efficiency. The lower limit of the thickness of the hole transport layer is more preferably 3 nm and the upper limit is more preferably 1000 nm. The lower limit is still more preferably 5 nm and the upper limit is still more preferably 500 nm.

The photoelectric conversion layer is not particularly limited as long as it contains an N-type semiconductor and a P-type semiconductor, and is preferably a layer including a layer (hereafter, also referred to as a sulfide layer) containing a sulfide of an element of group XV in the periodic table and a layer (hereafter, also referred to as an organic semiconductor layer) containing an organic semiconductor because such a photoelectric conversion layer improves the photoelectric conversion efficiency and durability of the resulting solar cell.

In such a photoelectric conversion layer, presumably, the sulfide layer mainly serves as an N-type semiconductor and the organic semiconductor layer mainly serves as a P-type semiconductor. The sulfide layer may partly serve as a P-type semiconductor and the organic semiconductor layer may partly serves as an N-type semiconductor. Such a photoelectric conversion layer may be a laminate including the sulfide layer and the organic semiconductor layer or a composite film obtainable by mixing and complexing the sulfide layer and the organic semiconductor layer. Preferred is a composite film because the electric charge separation efficiency of the organic semiconductor can be improved.

Examples of the semiconductor mainly serving as an N-type semiconductor in the photoelectric conversion layer include, in addition to the sulfide of an element of group XV in the periodic table, a sulfide (e.g., cadmium sulfide) of an element other than the element of group XV in the periodic table and an organic semiconductor (e.g., fullerene derivative).

The sulfide of an element of group XV in the periodic table is preferably antimony sulfide or bismuth sulfide, and more preferably antimony sulfide. Antimony sulfide is compatible with an organic semiconductor in terms of the energy level and absorbs more visible light than conventional zinc oxide or titanium oxide. Accordingly, when the sulfide of an element of group XV in the periodic table is antimony sulfide, the photoelectric conversion efficiency of the resulting solar cell is increased. Each of these sulfides of elements of group XV in the periodic table may be used alone, or two or more of these may be used in combination.

The sulfide of an element of group XV in the periodic table may be a complex sulfide containing two or more elements of group XV in the periodic table in one molecule.

The sulfide layer may contain another element in addition to the sulfide of an element of group XV in the periodic table as long as it does not impair the effect of the present invention. The other element is not particularly limited, and preferable examples thereof include elements in the fourth, fifth and sixth periods of the periodic table. Specific examples include indium, gallium, tin, cadmium, copper, zinc, aluminum, nickel, silver, titanium, vanadium, niobium, molybdenum, tantalum, iron, and cobalt. Each of these elements may be used alone, or two or more these may be used in combination. In particular, from the standpoint of enhancing the mobility of electrons, preferred are indium, gallium, tin, cadmium, zinc, and copper.

The upper limit of the amount of the other element (or the other elements) is preferably 50% by weight in the sulfide layer. When the amount is 50% by weight or less, the other element does not adversely affect the compatibility between the sulfide layer and the organic semiconductor and is less likely to cause a decrease in the photoelectric conversion efficiency.

The sulfide layer is preferably a crystalline semiconductor. When the sulfide layer is a crystalline semiconductor, the mobility of electrons is increased, leading to higher photoelectric conversion efficiency. Here, the crystalline semiconductor refers to a semiconductor whose scattering peaks can be detected by X-ray diffraction measurement or other techniques.

The degree of crystallinity may be employed as an index of the crystallinity of the sulfide layer. The lower limit of the degree of crystallinity of the sulfide layer is preferably 30%. When the degree of crystallinity is 30% or higher, the mobility of electrons is further improved, so that the photoelectric conversion is more improved. The lower limit of the degree of crystallinity is more preferably 50% and still more preferably 70%.

The degree of crystallinity can be determined as follows: scattering peaks derived from a crystalline fraction detected by X-ray diffraction measurement or other techniques, and halo derived from an amorphous fraction are separated by fitting; integrated intensities thereof are individually determined; and the proportion of the crystalline fraction in the whole is calculated.

For increasing the degree of crystallinity of the sulfide layer, the sulfide layer may be subjected to thermal annealing; irradiation with high-intensity light using a laser, flash lamp, or the like; excimer light irradiation; plasma irradiation; or the like treatment, for example. In particular, irradiation with high-intensity light, plasma irradiation, and the like method are preferred because oxidation of the sulfide of an element of group XV in the periodic table can be reduced.

The organic semiconductor is not particularly limited, and examples thereof include compounds having a thiophene structure such as poly(3-alkylthiophene). The examples also include conductive polymers having a polyparaphenylene vinylene structure, polyvinyl carbazole structure, polyaniline structure, polyacetylene structure, spirobifluorene structure, or the like structure. Moreover, the examples further include compounds having a phthalocyanine structure, a naphthalocyanine structure, a pentacene structure, and a porphyrin structure such as a benzoporphyrin structure. In particular, preferred are compounds having a thiophene structure, a phthalocyanine structure, a naphthalocyanine structure, or a benzoporphyrin structure because the durability is comparatively high.

The organic semiconductor may be an organic semiconductor as described above, namely an organic semiconductor having a carboxyl group and having a conjugated structure in a hole transport layer. In other words, the organic semiconductor having a carboxyl group and having a conjugated structure can serve as both the hole transport layer and the semiconductor that mainly serves as a P-type semiconductor in the photoelectric conversion layer.

The organic semiconductor is preferably of a donor-acceptor type because it can absorb light in a long wavelength region. In particular, more preferred is a donor-acceptor type compound having a thiophene structure. Among the donor-acceptor type compounds having a thiophene structure, particularly preferred is a thiophene-diketopyrrolopyrrole polymer from the standpoint of the light absorption wavelength.

In the case where the photoelectric conversion layer is a laminate, the lower limit of the thickness of the sulfide layer is preferably 5 nm and the upper limit thereof is preferably 5000 nm. When the thickness is 5 nm or more, such a layer can sufficiently absorb light, leading to further improvement of the photoelectric conversion efficiency. When the thickness is 5000 nm or less, generation of a region where the electric charge cannot be separated is suppressed, leading to improvement of the photoelectric conversion efficiency. The lower limit of the thickness of the sulfide layer is more preferably 10 nm and the upper limit thereof is more preferably 1000 nm, and the lower limit is still more preferably 20 nm and the upper limit is still more preferably 500 nm.

In the case where the photoelectric conversion layer is a laminate, the lower limit of the thickness of the organic semiconductor layer is preferably 5 nm and the upper limit thereof is preferably 1000 nm. When the thickness is 5 nm or more, such a layer can sufficiently absorb light, leading to further improvement of the photoelectric conversion efficiency. When the thickness is 1000 nm or less, generation of a region where the electric charge cannot be separated is suppressed, leading to improvement of the photoelectric conversion efficiency. The lower limit of the thickness of the organic semiconductor layer is more preferably 10 nm and the upper limit thereof is more preferably 500 nm, and the lower limit is still more preferably 20 nm and the upper limit is still more preferably 200 nm.

In the case where the photoelectric conversion layer is a composite film, the ratio of the sulfide layer and the organic semiconductor layer is very important. The ratio of the sulfide layer and the organic semiconductor layer is preferably 1:9 to 9:1 (volume ratio). If the ratio is outside the above range, holes or electrons may not reach the electrode, possibly leading to a decrease in the photoelectric conversion efficiency. The ratio is more preferably 2:8 to 8:2 (volume ratio).

The lower limit of the thickness of the composite film is preferably 30 nm and the upper limit thereof is preferably 3000 nm. When the thickness is 30 nm or more, such a film can sufficiently absorb light, leading to further improvement of the photoelectric conversion efficiency. When the thickness is 3000 nm or less, the electric charge can easily reach the electrode, leading to improvement of the photoelectric conversion efficiency. The lower limit of the thickness of the composite film is more preferably 40 nm and the upper limit thereof is more preferably 1000 nm, and the lower limit is still more preferably 50 nm and the upper limit is still more preferably 500 nm.

The solar cell of the present invention may further have an electron transport layer between the cathode and the photoelectric conversion layer.

The material of the electron transport layer is not particularly limited, and examples thereof include N-type conductive polymers, N-type low-molecular organic semiconductors, N-type metal oxides, N-type metal sulfides, alkali metal halides, alkali metals, and surfactants. Specific examples thereof include cyano group-containing polyphenylene vinylene, boron-containing polymers, bathocuproine, bathophenanthroline, hydroxyquinolinato aluminum, oxadiazole compounds, benzoimidazole compounds, naphthalenetetracarboxylic acid compounds, perylene derivatives, phosphine oxide compounds, phosphine sulfide compounds, fluoro group-containing phthalocyanine, titanium oxide, zinc oxide, indium oxide, tin oxide, gallium oxide, tin sulfide, indium sulfide, and zinc sulfide.

The lower limit of the thickness of the electron transport layer is preferably 1 nm and the upper limit thereof is preferably 200 nm. When the thickness is 1 nm or more, such a layer can sufficiently block holes. When the thickness is 200 nm or less, such a layer is less likely to be resistance upon electron transportation, avoiding a decrease in the photoelectric conversion efficiency. The lower limit of the thickness of the electron transport layer is more preferably 3 nm and the upper limit thereof is more preferably 150 nm, and the lower limit is still more preferably 5 nm and the upper limit is still more preferably 100 nm.

The production method of the solar cell of the present invention is not particularly limited. In an exemplary method, after formation of an electrode (anode) on a substrate, a hole transport layer is formed on the surface of the electrode (anode) by coating application or the like, and a photoelectric conversion layer is formed on the surface of the hole transport layer by a printing method (e.g., spin coating), vacuum evaporation, or the like method. Then, an electron transport layer is optionally formed on the surface of the photoelectric conversion layer, and an electrode (cathode) is formed on the surface of the electron transport layer. Alternatively, after formation of an electrode (cathode) on a substrate, an electron transport layer, a photoelectric conversion layer, a hole transport layer, and an electrode (anode) may be formed in said order.

### - Advantageous Effects of Invention

The present invention provides a solar cell having high photoelectric conversion efficiency and excellent durability.

### DESCRIPTION OF EMBODIMENTS

The present invention is specifically described in the following with reference to, but not limited to, examples.

### (Example 1)

On the surface of an ITO film as a transparent electrode (cathode), a TiO₂ layer was formed as an electron transport layer by spin coating. Next, a layer of antimony sulfide is formed on the surface of the TiO₂ layer by deposition, and on the surface of the resulting antimony sulfide layer, P3HT (product of Merck KGaA, conjugated polymer having a thiophene structure with a hexyl group at the 3-position, having a constituting unit represented by Formula (5), weight average molecular weight of 77500) was applied to the thickness of about 10 to 20 nm by spin coating, thereby forming a photoelectric conversion layer. Then, on the surface of the photoelectric conversion layer, P3CT (product of Rieke Metals Inc., conjugated polymer having a carboxyl group and having a thiophene structure, having a constituting unit represented by Formula (1) mentioned above, weight average molecular weight of 20000) was applied to a thickness of about 15 nm, thereby forming a hole transport layer. On the surface of the hole transport layer, gold is laminated as a metal electrode (anode) by deposition. In this manner, a solar cell was obtained.

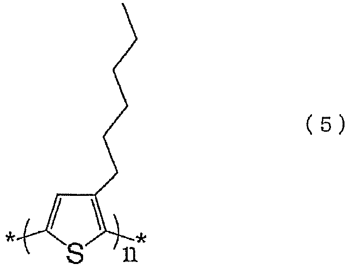

In Formula (5), n represents an integer.

### (Examples 2 to 9, Comparative Examples 1 to 10)

A solar cell was obtained in the same manner as in Example 1, except that materials shown in Tables 1 and 2 were used as the materials of the hole transport layer and the photoelectric conversion layer. Materials used in the examples and comparative examples are listed below.

### (1) Organic semiconductor having a carboxyl group and having a conjugated structure

· P3CT (product of Rieke Metals Inc., conjugated polymer having a carboxyl group and having a thiophene structure, having a constituting unit represented by Formula (1) mentioned above, weight average molecular weight of 20000)
· D-149 (having a structure represented by Formula (2) mentioned above, 5-[[4-[4-(2,2-Diphenylethenyl)phenyl]-1,2,3,3a,4,8b-hexahydrocyclopent[b]indol-7-yl]methylene]-2-(3-ethyl-4-oxo-2-thioxo-5-thiazolidinylidene)-4-oxo-3-thiazolidineacetic acid, product of Sigma-Aldrich)
· Paraphenylene vinylene derivatives (paraphenylene vinylene derivatives having a constituting unit represented by Formula (3) mentioned above, and having a carboxyl group introduced thereinto, weight average molecular weight of 50000)
· phthalocyanine derivatives (phthalocyanine derivatives having a structure represented by Formula (4) mentioned above and having a carboxyl group introduced thereinto)

### (2) Others

· P3HT (product of Merck KGaA, conjugated polymer having a thiophene structure with a hexyl group at the 3-position, having a constituting unit represented by Formula (5) mentioned above, weight average molecular weight of 77500)
· D-149 derivatives (D-149 wherein a carboxyl group is converted to an ester group by hydrolysis)
· PEDOT:PSS (poly(3,4-ethylene dioxythiophene):poly(styrene sulfonate))
· PE (polyethylene)
· α-6T (α-sexithiophene having a structure represented by Formula (6) mentioned below)
· DPP (3,6-Di(2-thienyl)-2,5-dihydropyrrolo[3,4-c]pyrrole-1,4-dione having a structure represented by Formula (7) mentioned below)
· MK-2 (organic semiconductor having a structure represented by Formula (8) mentioned below, product of Soken Chemical & Engineering Co., Ltd.)
· PCBM (fullerene derivative having a structure represented by Formula (9) mentioned below, product of Sigma-Aldrich)

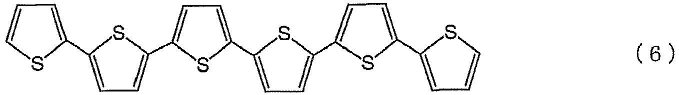

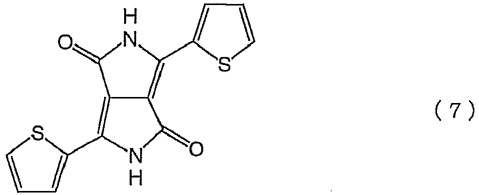

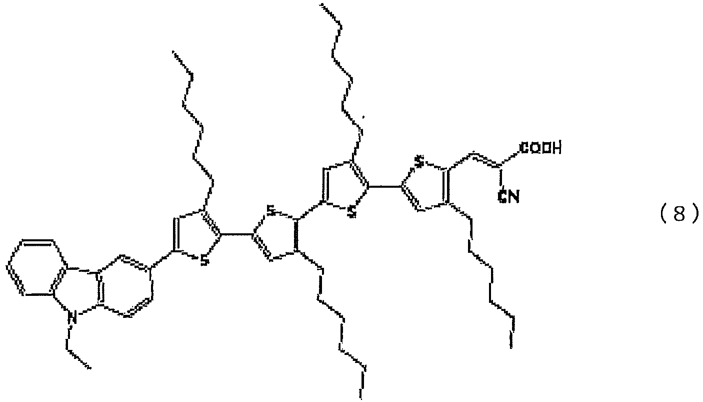

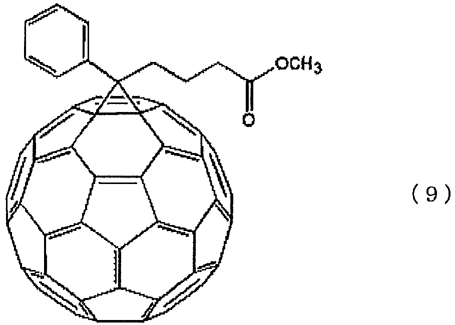

### <Evaluation>

Solar cells obtained in the examples and the comparative examples were evaluated for the following items. Tables 1 and 2 show the results.

### (1) Film forming properties of hole transport layer

Film forming properties when the hole transport layer was formed on the surface of the photoelectric conversion layer were evaluated based on the following criteria.
○ (Good): The film obtained was visibly homogeneous and uniform.
× (Poor): The film obtained was visibly inhomogeneous and non-uniform.

### (2) Measurement of photoelectric conversion efficiency and evaluation of durability

Using a solar cell characteristic evaluation system CEP-015 (product of Bunkokeiki Co., Ltd.), the current density-voltage characteristics of the solar cells were measured under irradiation with pseudo sunlight of AM1.5 (100 mW/cm²). The current density-voltage characteristics were normalized based on the current density-voltage characteristic (set to 1) of the solar cell of Example 1.

The current density-voltage characteristics of the solar cells not sealed in glass were measured after lapse of 72 hours under the conditions of a temperature of 60°C and a humidity of 30%. The durability was evaluated based on the value of the current density-voltage characteristic after lapse of 72 hours relative to the current density-voltage characteristic before lapse of 72 hours.

### (3) General evaluation

Evaluation was performed based on the following criteria.
○ (Good): Film forming properties of the hole transport layer was ○ (good), the photoelectric conversion efficiency was 0.8 or more, and the durability was 0.6 or more.
× (Poor): Film forming properties of the hole transport layer was × (Poor), the photoelectric conversion efficiency was less than 0.8, or the durability was less than 0.6.

**[Table 1]**

| | | Example 1 | Example 2 | Example 3 | Example 4 | Example 5 | Example 6 | Example 7 | Example 8 | Example 9 |
|---|---|---|---|---|---|---|---|---|---|---|
| Hole transport layer | Kind | P3CT | P3CT | P3CT | D-149 | paraphenylene vinylene derivative | phthalocyanine derivative | P3CT | P3CT | P3CT |
| | Carboxyl group | Present | Present | Present | Present | Present | Present | Present | Present | Present |
| | Conjugated structure | Present | Present | Present | Present | Present | Present | Present | Present | Present |
| Photoelectric conversion layer | | antimony sulfide | antimony sulfide, | antimony sulfide | antimony sulfide | antimony sulfide | antimony sulfide | cadmium sulfide | MK-2 | PCBM |
| | | P3HT | α-6T | DPP | P3HT | P3HT | P3HT | P3HT | P3HT | P3HT |
| Evaluation | Film forming peroperties of hole transport layer | ○ | ○ | ○ | ○ | ○ | ○ | ○ | ○ | ○ |
| | Photoelectric conversion efficiency | 1 | 0.92 | 1.01 | 0.85 | 0.92 | 0.9 | 0.8 | 0.8 | 0.9 |
| | Durability | 0.75 | 0.64 | 0.71 | 0.62 | 0.6 | 0.8 | 0.72 | 0.6 | 0.6 |
| | General evaluation | ○ | ○ | ○ | ○ | ○ | ○ | ○ | ○ | ○ |

**[Table 2]**

| | | Comparative Example 1 | Comparative Example 2 | Comparative Example 3 | Comparative Example 4 | Comparative Example 5 | Comparative Example 6 | Comparative Example 7 | Comparative Example 8 | Comparative Example 9 | Comparative Example 10 |
|---|---|---|---|---|---|---|---|---|---|---|---|
| Hole transport layer | Kind | Absent | PEDOT:PSS | P3HT | PEDOT:PSS | Absent | PEDOT:PSS | D-149 derivative | molybdenum oxide | citric acid | PE |
| | Carboxyl group | - | Absent | Absent | Absent | - | Absent | Absent | - | Present | Absent |
| | Conjugated structure | - | Present | Present | Present | - | Present | Present | - | Absent | Absent |
| Photoelectric conversion layer | | antimony sulfide | antimony sulfide | antimony sulfide | antimony sulfide | antimony sulfide | antimony sulfide | antimony sulfide | antimony sulfide | antimony sulfide | antimony sulfide |
| | | P3HT | P3HT | α-6T | α-6T | DPP | DPP | P3HT | P3HT | P3HT | P3HT |
| Evaluation | Film forming peroperties of hole transport layer | - | × | ○ | × | - | × | × | ○ | ○ | ○ |
| | Photoelectric conversion efficiency | 0.12 | 0.8 | 0.29 | 0.53 | 0.12 | 0.07 | 0.4 | 0.56 | 0 | 0 |
| | Durability | 0.06 | 0.49 | 0.12 | 0.33 | 0.07 | 0.04 | 0.15 | 0.39 | - | - |
| | General evaluation | × | × | × | × | × | × | × | × | × | × |

### - Industrial Applicability

The present invention can provide a solar cell having high photoelectric conversion efficiency and excellent durability.

## Claims

1. A solar cell comprising at least: a cathode; an anode; a photoelectric conversion layer provided between the cathode and the anode; and a hole transport layer provided between the photoelectric conversion layer and the anode,
the hole transport layer containing an organic semiconductor, the organic semiconductor having a carboxyl group and having a conjugated structure.

2. The solar cell according to claim 1,
wherein the organic semiconductor having a carboxyl group and having a conjugated structure is a conjugated polymer having a weight average molecular weight of 10000 to 1000000.

3. The solar cell according to claim 1 or 2,
wherein the organic semiconductor having a carboxyl group and having a conjugated structure has at least one structure selected from the group consisting of a thiophene structure, a paraphenylene vinylene structure, a vinyl carbazole structure, an aniline structure, an acetylene structure, a pyrrole structure, a perylene structure, a fluorene structure, an indoline structure, a spirobifluorene structure, a phthalocyanine structure, and a porphyrin structure.

4. The solar cell according to claim 1, 2, or 3,
wherein the photoelectric conversion layer includes a layer containing a sulfide of an element of group XV in the periodic table and a layer containing an organic semiconductor.

5. The solar cell according to claim 1, 2, 3, or 4, further comprising an electron transport layer between the cathode and the photoelectric conversion layer.
